# EUROPEAN PATENT APPLICATION

(11) **EP 4 811 592 A1**
(43) Date of publication of application: **23.09.2026**
(21) Application number: 25164908.3
(22) Date of filing: 20.03.2025
(51) Int. Cl.: H02J 3/38, G01R 27/02

(54) **METHOD AND CONTROL DEVICE FOR IMPEDANCE ESTIMATION OF AN ELECTRICAL POWER NETWORK**

(71) Applicant: Hitachi Energy Ltd, 8050 Zürich (CH)
(72) Inventor: Hasler, Jean-Philippe, 72244 Västerås (SE); Bongiorno, Massimo, 41 261 Göteborg (SE); Svensson, Jan, 72346 Västerås (SE); Liu, Wentao, 41281 Göteborg (SE)
(74) Representative: AWA Sweden AB

(57) **Abstract**

The present disclosure relates to a computer-implemented method for impedance estimation of an electrical power network, wherein a voltage source converter, VSC, is electrically connected to the electrical power network via a point of common connection, PCC, the method comprising: upon detecting a fault perturbing an impedance (*Z_{g}*) of the electrical power network so that a per-unit impedance (*Z_{g}*) of the electrical power network deviates from a pre-fault value, determining a set of data points (*x*ₖ, *y*ₖ) based at least on a plurality of measurements of an active power (*P_{g}*) and a reactive power (*Q_{g}*) being exchanged between the VSC and the electrical power network via the PCC; performing a circle fitting on the set of data points (*x*ₖ, *y*ₖ) to estimate a center point (*x_{c_est}, y_{c_est}*) and a radius (*r_{c_est}*) of a quasi-power circle (*C*_{qp}); and determining an estimated impedance (*Z_{g_est}*) of the impedance (*Z_{g}*) of the electrical power network based on the coordinates of the center point and radius, wherein *R_{g_est}* corresponds to an estimated fundamental frequency resistance of the electrical power network and *X_{g_est}* corresponds to an estimated fundamental frequency reactance of the electrical power network. A control device implementing the method and a power supporting system are also disclosed.

## Description

### Technical Field

The present disclosure relates to a method and control device for impedance estimation of an electrical power network, and a power supporting system comprising the control device.

### Background

Global climate change has driven efforts to reduce CO₂ emissions by shifting from fossil fuels to renewable energy sources like wind and solar. While these sources are sustainable, they are typically variable and/or intermittent. As a result, converter-based solutions are used for stable grid integration. However, unlike synchronous generators in conventional grids, converters inherently lack the rotational inertia that helps stabilize frequency and voltage. As a result, grids with renewable energy integration may be more vulnerable than conventional grids during faults.

In order to enhance stability of such grids, grid-forming converters may be utilized. By actively controlling voltage and frequency, they provide power support emulating the rotational inertia of synchronous generators, thus enhancing renewable energy integration. For effective operation, however, the required power support must be properly dimensioned in relation to grid impedance. As the actual grid impedance may not always be readily available an estimated grid impedance is often used to guide the converter in providing the necessary power support, particularly after a fault. In this document, by "grid impedance" it is intended the impedance of the grid at the fundamental frequency.

Accurately estimating a grid impedance can be challenging, particularly in weak power grids and during transient conditions. Grid impedance estimation is even more challenging when the estimator is based on local measurements only and is to be achieved without artificially perturbing the grid. Furthermore, the estimation speed might be a crucial factor in the selection of the most appropriate algorithm. As a result, the converter may dimension power support on an inaccurate grid impedance estimation, and thus provide insufficient or excessive power support, hindering rather than restoring fault recovery and grid stability.

In view of the above, there is a need for a method which can provide sufficiently accurate impedance estimations for weaker power grids.

### Summary

It is an object of the present disclosure to provide a solution that alleviates at least some drawbacks with present solutions. This and other objects, which will be implicitly and explicitly detailed in the following disclosure, are solved by one or more of the inventions defined in the claims. Additional advantageous embodiments are described in the following.

The present disclosure is based on the inventors' realization that for weak electrical power networks, in particular ultra-weak electrical power networks, equations for active power and reactive power can be modified to provide a quasi-power circle, which can be utilized to provide a sufficiently accurate impedance estimation of the electrical power network, even if there is a large shift in power angle after a fault. Thus, a sufficiently accurate impedance estimation can be obtained for weak electrical power networks, thereby facilitating a converter to provide the required power support to promote power angle stability and synchronization post-fault.

According to a first aspect of the present disclosure, a computer-implemented method for impedance estimation of an electrical power network is provided. A voltage source converter, VSC, is electrically connected to the electrical power network via a point of common connection, PCC. The method comprises: upon detecting a fault perturbing an impedance of the electrical power network so that a per-unit impedance *Z_{g}* of the electrical power network deviates from a pre-fault value, determining a set of data points (*x*ₖ, *y*ₖ) based at least on a plurality of measurements of an active power *P_{g}* and a reactive power *Q_{g}* being exchanged between the VSC and the electrical power network via the PCC. The method comprises: performing a circle fitting on the set of data points (*x*ₖ, *y*ₖ) to estimate a center point (*x*_{*c*_*est*}, *y_{c_esc}*) and a radius *r*_{*c*_*est*} of a quasi-power circle *C*_{qp} expressed using an equation of the form ${\left({P}_{traj}-{x}_{c _ est}\right)}^{2} + {\left({Q}_{traj}-{y}_{c _ est}\right)}^{2} = {r}_{c _ est}^{2}$ wherein ${P}_{traj} = function \left({P}_{g},{V}_{g},…\right)$ ${Q}_{traj} = function \left({Q}_{g},{V}_{g},…\right)$ wherein *V*_{g} corresponds to a voltage magnitude of a voltage at the PCC. The method comprises: determining an estimated impedance *Z_{g_est}* of the impedance *Z_{g}* of the electrical power network by ${R}_{g _ est} = \frac{{x}_{c _ est} {Z}_{b}}{{{x}_{c _ est}}^{2} + {{y}_{c _ est}}^{2}}$ ${X}_{g _ est} = \frac{{y}_{c _ est} {Z}_{b}}{{{x}_{c _ est}}^{2} + {{y}_{c _ est}}^{2}}$ ${Z}_{g _ est} = \sqrt{{{R}_{g _ est}}^{2} + {{X}_{g _ est}}^{2}}$ wherein *R_{g_est}* corresponds to an estimated fundamental frequency resistance of the electrical power network and *X_{g_est}* corresponds to an estimated fundamental frequency reactance of the electrical power network.

The method above advantageously enables a sufficiently accurate impedance estimation in a weak electrical power network, in particular an ultra-weak electrical power network (such as a power grid), which impedance estimation can be utilized by a control device to accurately control a converter, such as a VSC, to provide power support (e.g., active power and/or reactive power and/or frequency control etc.) for promoting power angle stability and synchronization.

The plurality of measurements of active power *P_{g}* and reactive power *Q_{g}* may be based on a plurality of voltage *V_{g}* and current *I_{g}* measurements at the PCC. The plurality of measurements of active power *P_{g}* and reactive power *Q_{g}* may be determined from a plurality of voltage and current phasors based on the plurality of voltage *V_{g}* and current *I_{g}* measurements at the PCC. The converter may be arranged locally with respect to the PCC. Thus, it may be said that the plurality of voltage and current (or the active power and reactive power) measurements are a plurality of local measurements. As a non-limiting example, the converter and the PCC may both be arranged in a substation electrically connected to the electrical power network, which electrical power network extends between at least two substations.

The current *I_{g}* at the PCC may be measured by a current measurement device, such as a current transformer (CT). The voltage at the PCC may be measured by a voltage measurement device, such as a voltage transformer (VT) or potential transformer (PT). These devices may step down the voltage and current signals to safe levels for further processing. The measured plurality of voltages and currents may be analog signals. The measured analog signals may be sampled and digitized using an analog-to-digital converter (ADC). The sampling frequency is to be selected so that the dynamics of interest can be measured; typically in the kHz range.

The voltage and current signals may be represented as complex phasors, where the magnitude corresponds to the root-mean-square (RMS) value of the signal, and the phase corresponds to the phase angle of a fundamental frequency component. Specifically, the voltage phasor V and the current phasor *I* may be expressed as: $V = \left|V\right| {e}^{{jθ}_{V}}$ $I = \left|I\right| {e}^{{jθ}_{I}}$ wherein |*V*| and |*I*| are the RMS magnitudes of the voltage and current, and *θ_{V}* and *θ_{I}* are the respective phase angles. The active power P and reactive power Q may be estimated based on the voltage and current phasors. The active power may be determined as the real component of the apparent power S. The apparent power *S* may be determined as the complex product of the voltage phasor and the complex conjugate of the current phasor: $S = VI * = {P}_{g} + {jQ}_{g}$ or alternatively ${P}_{g} = {V}_{g , rms} {I}_{g , rms} cos \left({θ}_{V}-{θ}_{I}\right)$ ${Q}_{g} = {V}_{g , rms} {I}_{g , rms} sin \left({θ}_{V}-{θ}_{I}\right)$

These calculations may be performed in real time by a digital signal processor (DSP) or another processing unit. In some implementations, a phasor measurement unit (PMU) may be used to directly estimate the phasors and compute the power components. This approach enables accurate monitoring and control of power flow, particularly in systems with high renewable energy penetration, where real-time adaptation to changing grid conditions may be necessary. A control device of the present disclosure (described in the following) may comprise any one of a processing unit for performing the above calculations or the phasor measurement unit, PMU.

After the plurality of measurements of active power *P_{g}* and reactive power *Q_{g}* is obtained, the set of data points (*x*ₖ, *y*ₖ) is determined based at least on the plurality of measurements of active power *P_{g}* and reactive power *Q_{g}.* A circle fitting is then performed on the set of data points (*x*ₖ, *y*ₖ) to estimate a center point (*x*_{*c*_*est*}, *y_{c_esc}*) and a radius *r*_{*c*_*est*} of a quasi-power circle *C*_{qp}. The quasi-power circle *C*_{qp} may be a quasi-power circle represented in a coordinate system, wherein a first parameter *P*ₜᵣₐⱼ based on the active power *P_{g}* is represented horizontally and a second parameter *Q*ₜᵣₐⱼ based on the reactive power *Q_{g}* is represented vertically. The first parameter *P*ₜᵣₐⱼ may be expressed by a function at least in terms of active power *P_{g}* and voltage *V_{g}* at the PCC. The second parameter *Q*ₜᵣₐⱼ may be expressed by a function at least in terms of active power *Q_{g}* and voltage *V_{g}* at the PCC. It should be understood that the functions of the first parameter and the second parameter may also take into account other parameters, such as a base impedance. Once the center point (*x*_{*c*_*est*}, *y_{c_esc}*) has been estimated, an estimated impedance *Z_{g_est}* may then be determined for the electrical power network.

As mentioned, the method advantageously enables a sufficiently accurate impedance estimation of a weak electrical power network after a fault. Generally, the term "weakness" at a given point in a power system is related to the ability to transfer power in steady-state while maintaining adequate level of voltage and frequency stability. Short-circuit ratio, SCR, is one way of quantifying the weakness of a power system. A study *(*Stability-Enhancing Measures for Weak Grids, Milestone 2 Report, Jayasinghe, G., Bahrani, B., Monash University, June 2021) characterizes a weak grid as a grid having a SCR in an interval of 3 < SCR < 5 and a very weak grid as a grid having a SCR in an interval SCR < 3.

A SCR in an interval of SCR≥5 may correspond to a strong electrical power network.

A SCR in an interval of 3≤SCR<5 may correspond to a weak electrical power network.

A SCR in an interval of 1≤SCR<3 may correspond to a very weak electrical power network.

A SCR in an interval of SCR<1 may correspond to an ultra-weak electrical power network.

SCR may correlate inversely with impedance in per unit of the electrical power network. That is, an electrical power network e.g., dropping from a first SCR equal to 4 to a second SCR equal to 1 after a fault presents a post-fault impedance approximately equal to 4 times the pre-fault impedance.

The method may advantageously provide sufficiently accurate impedance estimations of an electrical power network (such as a power grid) for weak electrical power networks, in particular ultra-weak electrical power networks.

According to one embodiment, the parameters *P*ₜᵣₐⱼ, *Q*ₜᵣₐⱼ are determined by ${P}_{traj} = \frac{{P}_{g} {Z}_{b}}{{V}_{g}^{2}}$ ${Q}_{traj} = \frac{{Q}_{g} {Z}_{b}}{{V}_{g}^{2}}$ wherein *P*ₜᵣₐⱼ, *Q*ₜᵣₐⱼ define a plurality of quasi-power points of the quasi-power circle *C*_{qp}, *V*_{g} corresponds to a voltage magnitude of a voltage at the PCC, *Z_{b}* corresponds to a base impedance, and *P*_{g} and *Q*_{g} are based on measurements of voltage *V*_{g} and current *I*_{g} at the PCC. By defining the parameters *P*ₜᵣₐⱼ, *Q*ₜᵣₐⱼ as above, the center-point of the quasi-power circle may be directly used in the equations for estimating the impedance of the electrical power network. It should be understood that the parameters may be scaled or defined using other functions. In such cases, the center point (*x_{c_est}*, *y_{c_esc}*) may be modified accordingly before being used in the equations for estimating the impedance of the electrical power network.

The base impedance *Z_{b}* may be determined based at least on a base power *S_{b}* of the converter being exchanged between the converter and the electrical power network via the PCC and a base voltage *V_{b}* of the converter at which the converter provides the base power *S_{b}*. The base impedance *Z_{b}* may be determined as ${Z}_{b} = \frac{{V}_{b}^{2}}{{S}_{b}}$

**According** to one embodiment, the set of data points (*x*ₖ, *y*ₖ) are defined as ${x}_{k} = {P}_{traj} \left(k\right)$ ${y}_{k} = {Q}_{traj} \left(k\right)$ wherein k indicates a *k*:th data point. Thus, each data point comprises a first coordinate value *x*ₖ based on the first parameter *P*ₜᵣₐⱼ and a second coordinate value *y*ₖ based on the second parameter *Q*ₜᵣₐⱼ. It should be understood that the number of data points included in the set of data points may depend on the time resolution and/or the level of accuracy required. The set of data points may correspond to a series of time-domain measurements of at least voltage and current. According to a non-limiting example, the data points are sampled by a sampling frequency corresponding to at least 200 times the fundamental frequency of the electrical power network (e.g., 50 Hz or 60 Hz), thus resulting in a number of data points of 10000+ per second.

According to one embodiment, the radius *r_{c_esc}* of the quasi-power circle *C*_{qp} is approximated as ${r}_{c _ est} \approx \frac{{V}_{s} {Z}_{b}}{{V}_{g} \left|{Z}_{g _ est}\right|}$ wherein *Uₛ* is the voltage magnitude of the voltage of the electrical power network and |*Z_{g_est}*| is the absolute value of the estimated fundamental frequency impedance of the electrical power network.

According to one embodiment, the radius *r*_{*c*_*est*} is approximated using parameters *Vₛ*, *Z_{b}*, *V_{g}*, *Z_{g_est}* expressed relative a respective base value, and the voltage magnitude of the voltage of the electrical power network *Vₛ* is selected to be equal to 1 per unit base value. Thus, the voltage magnitude of the voltage of the electrical power network *Vₛ* need not be measured. That is, it is assumed that the voltage magnitude of the voltage of the electrical power network does not change as a consequence of the fault, or at least does not change fast enough, so that it can be treated as a constant for the time duration of the impedance estimation. This advantageously enables the method to rely on local measurements of voltage and current (i.e., measurements of voltage and current at the PCC). This facilitates real-time application of the method, so that a control device may respond in real-time to a fault as soon as it occurs, i.e., by controlling the converter to provide the required power support to maintain power angle stability and synchronization.

According to one embodiment, the method comprises: computing a change of active power Δ*P_{g}* at the PCC, and detecting the fault when the change of active power Δ*P_{g}* at the PCC exceeds a predetermined threshold. The active power at the PCC may be determined based at least on voltage and current at the PCC. The change of active power may be determined as the difference between a present value of active power and a nominal active power. That is, after a fault, which results in the impedance of the electrical power network to increase, the active power may decrease by at least a predetermined threshold. Such an event may be used to detect a fault. The predetermined threshold may be in an interval of 5-10% of nominal active power. Implementing this type of fault detection is particularly advantageous as it enables fault detection based on local measurements alone (i.e., measurements of e.g., voltage and current at the PCC). However, it should be understood that other methods of fault detection may be implemented.

According to one embodiment, the method comprises: computing an error value *Err_{stageI}* based at least on the at least one local parameter; determining whether the error value is outside a predetermined error interval, and determining a start time of the circle fitting based at least on whether the error value is outside a predetermined error interval. Immediately after a fault, there may be transients in current and voltage causing relatively large momentary swings in active power and/or reactive power. Thus, it may be advantageous to delay circle fitting until the transients have lapsed to at least a degree. The at least one local parameter may be one of the voltage and the current at the PCC, or one of the active power and the reactive power. The error value may be based on two or more local parameters. The predetermined error interval may be defined by at least one error threshold, i.e., the predetermined error interval may be defined as any error being equal to or exceeding the at least one error threshold. That is, when the error is outside the predetermined error interval, i.e., when the error is sufficiently small, the start time of the circle fitting may be determined.

According to one embodiment, the error value is computed by the error function ${Err}_{stageI} = \sum \left[{\left({P}_{traj}-{P}_{traj _ ave}\right)}^{2}+{\left({Q}_{traj}-{Q}_{traj _ ave}\right)}^{2}\right]$ wherein *P_{traj_ave}* and *Q*_{*traj*_*ave*} are sliding window filtered values of *Pₜᵣₐⱼ* and *Qₜᵣₐⱼ*, respectively. Sliding window averages (or moving averages) may be used to smooth out fluctuations in the parameters *Pₜᵣₐⱼ*, *Qₜᵣₐⱼ*, by averaging the values of the parameters over a window of certain size N. This may advantageously prevent start of circle fitting before transients have lapsed or prevent transients from having a too large impact. The windows size N determines how many samples are considered in the average at each point. As a non-limiting example, N may be in an interval of 10-50, 50-100, 100-150, 150-200, 200 or more, or in an interval formed by any combination thereof. According to a non-limiting example, the sliding window filtered values *P_{traj_ave}* and *Q*_{*traj*_*ave*} of *Pₜᵣₐⱼ* and *Qₜᵣₐⱼ* respectively may be determined as ${P}_{{traj}_{ave}} \left(k\right) = \frac{1}{N} {\sum }_{i = 0}^{N - 1} {P}_{traj} \left(k-i\right)$ ${Q}_{{traj}_{ave}} \left(k\right) = \frac{1}{N} {\sum }_{i = 0}^{N - 1} {Q}_{traj} \left(k-i\right)$

According to one embodiment, the estimation of the center point (*x*_{*c*_*est*}, *y_{c_esc}*) and the radius *r*_{*c*_*est*} of the quasi-power circle *C*_{qp} comprises at least one of: an algebraic fitting method; a geometric fitting method; an adaptive filtering method; a Bayesian estimation method, and a transform-based method. Each of these methods may present distinct advantages depending on the nature of the data and the requirements of the application.

Algebraic fitting methods, such as the Least Mean Squares (LMS) method, may advantageously reduce, preferably minimize, an algebraic error between data points in the set of data points and the equation of the quasi-power circle. These methods are generally computationally efficient and suitable for circle fitting.

Geometric fitting methods, such as the Random Sample Consensus (RANSAC) algorithm, may advantageously reduce, preferably minimize, a perpendicular distance between data points in the set of data points and a fitted circle, providing a more robust fit than algebraic methods.

Adaptive filtering methods, such as the Recursive Least Squares (RLS) algorithm or the Kalman filter, may dynamically update the circle's parameters (center and radius) as new data points are collected. These methods are especially useful in real-time implementation of circle fitting.

Bayesian estimation methods, such as the Extended Kalman Filter (EKF), may incorporate prior knowledge about the quasi-power circle's parameters and probabilistically update them based on new data. These methods are useful when the data is uncertain or noisy, and prior information about the system is available to guide the fitting process (e.g., what the set of data points typically look like for various types of faults).

Transform-based methods, such as the Hough Transform, may map data points into a parameter space where the quasi-power circle's parameters can be more easily identified. These methods are particularly robust against noise and incomplete data.

It should be understood that the above examples are non-limiting examples on how to perform the circle fitting, and that other methods may be equally used.

According to one embodiment, the estimation of the center point (*x*_{*c*_*est*}, *y_{c_esc}*) and the radius *r*_{*c*_*est*} of the quasi-power circle *C*_{qp} comprises at least a least squares method. The least squares method may be a Recursive Least Squares (RLS) method. The RLS method may be employed to iteratively estimate the center point and radius of the quasi-power circle by reducing, preferably minimizing, the squared error between the measured data points and the circle equation. Unlike standard least squares methods, RLS may update the circle parameters dynamically as new data points become available, eliminating the need to recalculate the fit from scratch. This makes RLS highly suitable for real-time implementation of circle fitting, thus also facilitating impedance estimation for real-time application.

According to one embodiment, the recursive least squares method is subject to the constraint ${y}_{c _ est} > {x}_{c _ est} > 0$

This may advantageously facilitate the RLS method to converge to a more accurate circle fitting, thereby enhancing robustness of the method. Based on the physical interpretation of the true quasi-power circle center, where both coordinates are positive and the power line is typically inductive, the estimated circle center is subject to the constraint *y_{c_est} > x_{c_est} >* 0. In other words, the circle fitting process may begin to check for convergence only when the center of the fitted circle lies within the constrained range.

According to one embodiment, the circle fitting is an iterative process, and the method comprises: terminating the fitting process based at least on one termination condition, wherein the termination condition is at least one of: a convergence criteria of the radius and/or the circle center: a maximum number of iterations, and a variance *Var_{cc}* being below a predetermined variance threshold *Varₜₕ.* Thus, the method may advantageously prevent over fitting, thus speeding up the impedance estimation. It should be understood that other termination conditions may be utilized.

According to one embodiment, the termination condition is a variance *Var_{cc}* being below a predetermined variance threshold *Varₜₕ*, and the method comprises: computing the variance (*Var_{cc}*) between a newest fitted circle center (*x_{c_est}*[*k*], *y_{c_est}*[*k*]) and the M previous fitted circle centers as ${Var}_{cc} = \frac{1}{M} {\sum }_{i = 1}^{M} \left[{\left({x}_{c _ est}\left[k\right]-{x}_{c _ est}\left[k-i\right]\right)}^{2}+{\left({y}_{c _ est}\left[k\right]-{y}_{c _ est}\left[k-i\right]\right)}^{2}\right]$ and terminating the circle fitting when the variance is below the predetermined threshold (*Varₜₕ*). This termination condition is particularly advantageous when utilizing a RLS method for circle fitting.

According to one embodiment, the circle fitting is further based at least on a set of virtual quasi-power points (*x*₀, *y*₀) near the quasi-power circle *C*_{qp}. If the measured data points are sparse or unevenly distributed, virtual points can fill in the gaps to create a more balanced dataset. This can help circle fitting algorithms (like RLS methods or RANSAC) converge to a more accurate solution by preventing bias due to outlier data points in the set of data points.

According to one embodiment, wherein, during the detected fault, the electrical power network operates with a short-circuit ratio, SCR, within at least one predetermined SCR interval. As a non-limiting example, at least one predetermined interval is any one of 3≤SCR<5 (weak electrical power network); 1≤SCR<3 (very weak electrical power network); and SCR<1 (ultra-weak electrical power network).

According to one embodiment, the SCR is determined as $SCR = \frac{1}{{Z}_{g _ est}} = \frac{1}{\sqrt{{{R}_{g _ est}}^{2} + {{X}_{g _ est}}^{2}} / {Z}_{b}}$

This advantageously enables the SCR to be estimated based on the estimated impedance *Z_{g_est}.* The estimated SCR may impact further control operations of a converter, or determine different values of active power reference for the converter.

According to a second aspect of the disclosure, a control device is provided. The control device is configured to control a voltage source converter, VSC, electrically connected to an electrical power network via a point of common connection, PCC, the control device configured to: generate a VSC voltage reference based at least on an active power reference *P_{ref}* for an active power *P_{g}* being exchanged between the VSC and the electrical power network, wherein the active power reference *P_{ref}* is determined based at least on an estimated impedance *Z_{g_est}* determined by the method according to the first aspect or any embodiments thereof, wherein the control device is configured to provide the VSC voltage reference to the VSC for controlling the VSC.

The control device according to the second aspect may advantageously be used for controlling the VSC (which may be a grid-forming converter) to facilitate and maintain synchronism of an electrical power network when receiving power from renewable power generation sources, such as off shore wind farms.

The control device may comprise at least one processing unit configured to execute instructions corresponding to the method according to the first aspect or any embodiments thereof. The control device may comprise a memory for storing said instructions. The memory may be configured to store control logic, threshold values, and historical data for adaptive control. The control device may be communicatively connected to at least one measurement device for measuring at least one parameter of the electrical power network and/or the converter. For instance, the at least one measurement device may comprise a current transformer (CT) and/or a voltage transformer (VT) for measuring a current and a voltage at the PCC, respectively. The control device may be configured to determine at least one parameter of the electrical power network and/or the converter based on measurements of current and/or voltage. For instance, the control device may be configured to determine active power and reactive power based on current and voltage measurements. The control device may comprise a power supply unit for providing electrical power to components of the control device. The control device may comprise a communication module for facilitating communication between the control device and the converter. The control device may be configured to receive input from an operator via a user interface. This may allow a user to change a predetermined setting, such as a predetermined SCR interval or an active power reference.

According to one embodiment, the active power reference is determined as ${P}_{ref} = {αP}_{line _ max}$ wherein *α* is a predetermined scaling factor which is positive and smaller than 1 and *P*_{*line*_*max*} is the maximum active power transfer capacity determined as ${P}_{line _ max} = \frac{{R}_{g _ est}}{{\left|{Z}_{g _ est}\right|}^{2}} {{V}_{g}}^{2} + \frac{1}{\left|{Z}_{g _ est}\right|} {V}_{g}$

This may advantageously increase, preferably optimize, the active power transmission between the converter and the electrical power network via the PCC post-fault. The predetermined scaling factor may be selected to increase, preferably optimize, active power transmission while accounting for a margin of safety with respect to the maximum active power transfer capacity. This advantageously allows for fluctuations in active power without exceeding the maximum active power transfer capacity post-fault.

According to one embodiment, the control device is configured to provide a VSC voltage reference to the VSC for controlling the VSC, wherein an internal frequency of the VSC is controlled by the VSC voltage reference. The VSC voltage reference may specify both a voltage magnitude reference and a voltage phase reference for the VSC. Thus, the control device may control the VSC accordingly in response to a fault resulting in a SCR drop.

According to one embodiment, the control device comprises an active power controller. The active power controller may be configured to output an electromotive force phase for the VSC. The control device may be configured to determine the VSC voltage reference based at least on a VSC virtual electromotive force for the VSC, wherein the VSC virtual electromotive force is based at least on a electromotive force voltage and the electromotive force phase.

According to one embodiment, the control device further comprises: a virtual admittance unit configured to determine a current reference based at least on a voltage input multiplied with a virtual admittance, wherein the voltage input is based at least on a voltage difference between the VSC virtual electromotive force and the voltage at the PCC, wherein the virtual admittance is based at least on a virtual impedance between the VSC virtual electromotive force and said PCC.

According to a third aspect of the disclosure, a power supporting system is provided. The power system comprises: a voltage source converter, VSC, configured to be electrically connectable to an electrical power network via a point-of-common-coupling, PCC, and a control device according to the second aspect or any embodiments thereof. The power supporting system may comprise a plurality of VSC. The control device may be configured to control the plurality of VSC individually. At least one VSC may be electrically connected or connectable to a renewable energy source, such as a solar farm or a wind farm (onshore or offshore).

According to one embodiment, the power supporting system is configured to provide power support to an electrical power network, wherein the network is configured to transmit electrical energy at high voltage (HV), medium voltage (MV), or low voltage (LV) between a first location and a second location. The first location may be a first substation, and the second location may be a second substation. The power supporting system may be arranged at a substation. The voltage at the point of common coupling (PCC) may be HV, MV, or LV. The electrical power network may comprise at least one power line for transmitting electrical energy, wherein the power line may include at least one conductor for transmitting a respective phase of electrical current.

HV typically refers to voltages that exceed those used for residential and/or commercial applications, with specific thresholds depending on the region. For example, the International Electrotechnical Commission (IEC) generally considers alternating current (AC) voltages of 1000 V or more, and direct current (DC) voltages of 1500 V or more, to be classified as high voltage. More specifically, HV may refer to electrical voltage levels equal to or greater than 35 kV and up to several hundred kilovolts.

MV typically refers to electrical voltage levels that are higher than LV, but lower than HV. MV typically includes voltages equal to or greater than 1 kV but less than 35 kV. These voltage levels are commonly used for power distribution within urban or industrial settings and for the transmission of power to transformers that supply end-user loads.

LV typically refers to electrical voltage levels that are used for residential, commercial, and light industrial applications. LV typically includes voltages less than 1 kV, with the most common being 230 V for residential use and 400 V for commercial and industrial applications. LV power lines may be used to distribute electrical power directly to end users, such as homes, businesses, and small industries.

It should be understood that any one power line connected between the first substation and the second substation may be any one of a HV, MV, or LV power line.

According to one embodiment, the converter of the power supporting system is configured to electrically connect to an energy storage system (ESS) and/or operate as a static synchronous compensator (STATCOM). When electrically connected to the ESS, the converter is configured to charge or discharge the ESS to supply active power to the electrical power network or absorb excess power. When operating as a STATCOM, the converter is configured to provide reactive power compensation by injecting or absorbing reactive power to regulate the voltage at the point of common coupling (PCC). The converter may be configured to transition between ESS and STATCOM operation modes based on network conditions, thereby enhancing grid stability, supporting voltage regulation, and improving power quality. Particularly, the converter may be configured to operate as an E-STATCOM (Enhanced STATCOM) by providing both reactive power support and active power support via the ESS.

According to one embodiment, the power supporting system is configured to provide power support to an electrical power network electrically connected to at least one renewable power generation source. Non-limiting examples of renewable power generation sources include wind farms (on-shore or off-shore), solar farms, and wave power farms. The power supporting system may be configured to provide grid-forming control of the electrical power network. When fluctuations occur in the output of the renewable power generation source, the power supporting system may supply or absorb power by either providing active power through an energy storage system (ESS) or regulating voltage with reactive power compensation. This power support stabilizes voltage and/or frequency within the electrical power network, facilitating the integration of renewable energy sources and improving overall grid stability. The electrical power network may be a power grid or a separate power network.

According to a fourth aspect, a computer program is provided. The computer program comprises instructions which, when the program is executed by a computer, cause the computer to carry out the method according to the first aspect or any embodiments thereof.

According to a fifth aspect, a computer-readable storage medium is provided. The computer-readable storage medium comprises instructions which, when executed by a computer, cause the computer to carry out the method according to the first aspect or any embodiments thereof.

Effects and features of the second and third and fourth and fifth aspects are largely analogous to those described above in connection with the first aspect. Embodiments mentioned in relation to the first aspect are largely compatible with the second and third and fourth and fifth aspects. It is further noted that the inventive concepts relate to all possible combinations of features unless explicitly stated otherwise.

The invention is defined by the appended independent claims, with embodiments being set forth in the appended dependent claims, in the following description and in the drawings. It is to be understood that this disclosure is not limited to the particular component parts of the device described or steps of the methods described as such device and method may vary. It is also to be understood that the terminology used herein is for purpose of describing particular embodiments only, and is not intended to be limiting. It must be noted that, as used in the specification and the appended claims, the articles "a", "an", "the", and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings do not exclude other elements or steps.

Generally, all terms used in the claims are to be interpreted according to their ordinary meaning in the technical field, unless explicitly defined otherwise herein. All references to "a/an/the [element, device, component, means, step, etc.]" are to be interpreted openly as referring to at least one instance of said element, device, component, means, step, etc., unless explicitly stated otherwise.

### Brief Description of the Drawings

The invention will in the following be described in more detail with reference to the enclosed drawings, wherein:
Fig. 1a schematically illustrates a power supporting system according to some embodiments;
Fig. 1b illustrates a single-line diagram of a power supporting system according to some embodiments;
Figs. 2a-2b schematically illustrates a power supporting system according to some embodiments;
Figs. 2c-2e schematically illustrate different embodiments of a voltage source converter;
Fig. 3 schematically illustrates a control device according to some embodiments;
Fig. 4a illustrates a quasi-power circle determined according to some embodiments;
Fig. 4b illustrates a process of circle fitting according to some embodiments;
Fig. 5 illustrates a time evolution of a control operation of a converter electrically connected to an electrical power network via a PCC when said control operation is based on an estimated impedance by the method according to some embodiments;
Figs. 6 illustrates a flow chart of a method of controlling a converter according to some embodiments.

### Description of Embodiments

Hereinafter, the principle of the present disclosure will be described with reference to illustrative embodiments. It should be understood that all these embodiments are given merely for the person skilled in the art to better understand and further practice the present disclosure, but not for limiting the scope of the present disclosure. For example, features illustrated or described as part of one embodiment may be used with another embodiment to yield still a further embodiment. In the interest of clarity, not all features of an actual implementation are described in this specification. It will of course be appreciated that in the development of any such actual embodiment, numerous implementation-specific decisions should be made to achieve the developers' specific goals, such as compliance with system-related and business-related constraints, which will vary from one implementation to another. Moreover, it will be appreciated that such a development effort might be complex and time-consuming but would nevertheless be a routine undertaking for those of ordinary skill in the art having the benefit of this disclosure.

The disclosed subject matter will now be described with reference to the attached drawings. Various structures, systems and devices are schematically depicted in the drawings for purposes of explanation only and so as to not obscure the description with details that are well known to those skilled in the art. Nevertheless, the attached drawings are included to describe and explain illustrative examples of the disclosed subject matter. The words and phrases used herein should be understood and interpreted to have a meaning consistent with the understanding of those words and phrases by those skilled in the relevant art. No special definition of a term or phrase, i.e., a definition that is different from the ordinary and customary meaning as understood by those skilled in the art, is intended to be implied by consistent usage of the term or phrase herein. To the extent that a term or phrase is intended to have a special meaning, i.e., a meaning other than that understood by skilled artisans, such a special definition will be expressly set forth in the specification in a definitional manner that directly and unequivocally provides the special definition for the term or phrase.

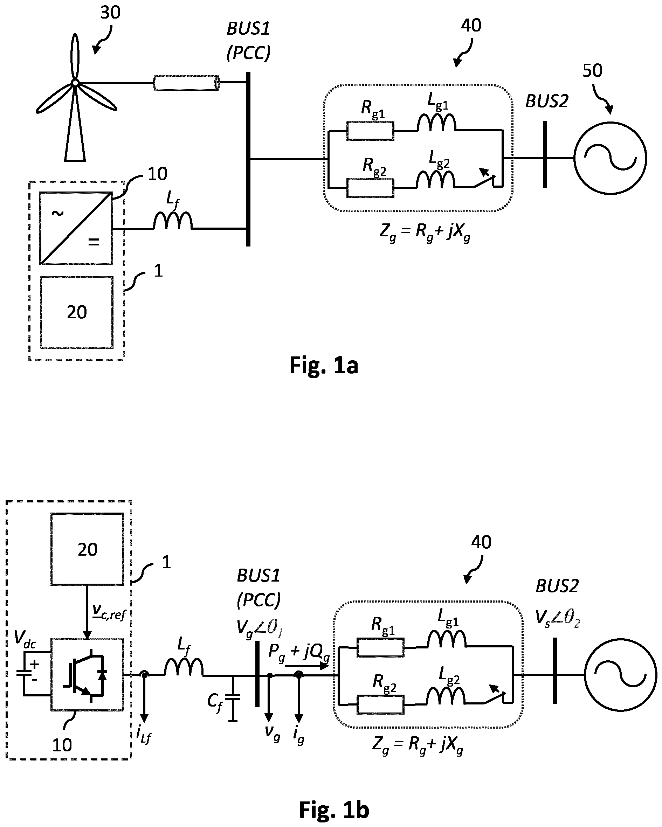

Fig. 1a schematically illustrates a power supporting system 1 according to some embodiments electrically connected to a first power generation source 30, such as a wind farm (on-shore or off-shore), and an electrical power network 40. The power supporting system 1 comprises a converter 10 and a control device 20. The converter 10 may be a voltage source converter, VSC. The converter 10 may be a grid-forming converter. The control device 20 is configured to be communicatively connected to the converter 10. The control device 20 is configured to control the converter 10 according to an enhanced power control method that will be described in more detail in the following. The power supporting system 1, the first power generation source 30, and the electrical power network 40 are electrically connected via a first bus, BUS1. The first bus BUS1 may serve as a point of common connection, PCC, for e.g. the converter 10 of the power supporting system 1 and the electrical power network 40. The electrical power network 40 is further electrically connected to a second power generation source 50 via a second bus, BUS2. It should be noted that Fig.1 represents a simple schematic for illustrative purposes, and the electrical power network 40 may exhibit significantly greater complexity, with various additional components and subsystems electrically connected thereto.

As mentioned, the first power generation source 30 may be a wind farm. It should be understood that the first power generation source 30 may be other forms of power generation sources. However, in order to illustrate the enhanced power control method implemented by the control device 20, an electrical power network 40 that may become weak, very-weak, or ultra-weak is taken as an example. Such scenarios may occur with renewable power sources, such as wind farms. It should therefore be understood that while the enhanced power control method and control device 20 implementing the same are described in the context of an electrical power network 40 electrically connected to a wind farm, the method and control device 20 are not as such limited thereto. On the contrary, the method and control device 20 may be implemented to control a converter 10 electrically connected to any type of electrical power network 40 that may be subject to a fault rendering the electrical power network to be weak, very weak, and ultra-weak.

The terms weak, very-weak, and ultra-weak may correspond to a particular short-circuit ratio. For instance, a weak electrical power network may correspond to a SCR less than 5 but greater than or equal to 3. For instance, very-weak may correspond to a SCR less than 3 but greater than or equal to 1. For instance, ultra-weak may correspond to a SCR less than 1. It should be understood that these SCR values and intervals depend on the manner in which the SCR is calculated. As one example, the SCR may be determined as $SCR = \frac{1}{{Z}_{g}} = \frac{1}{\sqrt{{{R}_{g}}^{2} + {{X}_{g}}^{2}} / {Z}_{b}}$ wherein *Z_{g}* is a per-unit value of the fundamental frequency impedance of the electrical power network 40, *R_{g}* is the fundamental frequency resistance of the electrical power network, *X_{g}* is the fundamental frequency reactance of the electrical power network, and Z_{b} is the base impedance of the power supporting system 1. These parameters of the electrical power network may be provided based on current and voltage measurements at the PCC. Voltage measurements may be obtained using Voltage Transformers (VTs) or resistive dividers. Current measurements may be captured via Current Transformers (CTs), Hall-effect sensors, or Rogowski coils. The electrical parameters, such as active power, reactive power, resistance, reactance, etc. may be determined based on the measured currents and voltages at the PCC.

As mentioned, the electrical power network 40 is electrically connected with the first power generation source 30 via the first bus BUS1. The first power generation source 30 is configured to convert some form of energy to electrical energy. As a non-limiting example, if the first power generation source 30 is a wind farm, then the wind farm may comprise at least one wind turbine configured to convert wind energy into electrical energy. It should however be understood that the first power generation source 30 may be a solar farm or a wave power farm or other types of renewable power generation sources or other power generation sources. The output of the first power generation source 30 is coupled to BUS1 via a cable, enabling the transmission of generated electrical power to the converter 10 and the electrical power network 40. In some embodiments, the converter 20 is configured to condition the electrical power received from the first power generation source 30, for example, by performing voltage regulation, frequency adjustment, or harmonic filtering, to ensure compliance with requirements of the electrical power network or to improve, preferably optimize, power transmission characteristics.

The power supporting system 1 comprises a converter. According to one non-limiting example, the converter may be configured to operate as a static synchronous compensator, STATCOM, configured to inject or absorb reactive power. In such a case, the converter is configured to exchange reactive power with the electrical power network. The converter may inject reactive power to raise the voltage at the PCC or absorb reactive power to lower the voltage at the PCC, thereby regulating voltage levels and enhancing grid stability. The control device 20 may be configured to dynamically adjust the reactive power output based on voltage measurements at the PCC. According to one non-limiting example, the power supporting system 1 may comprise an energy storage system, ESS, electrically connected to the converter 10. The ESS may comprise at least one energy storage module, such as a battery bank, a supercapacitor, or a flywheel, for storing energy. The converter 10 may thus be configured to exchange both active power and/or reactive power with the electrical power network via the PCC. The system may inject active power into the network during periods of low generation or high demand, and absorb active power to charge the ESS when excess power is available.

In e.g., Fig. 1a, the electrical power network 40 is schematically illustrated with two parallel power lines. Each power line is characterizable by a resistance R_{g1}, R_{g2} and an inductance L_{g1}, L_{g2}. Each power line impacts an impedance of the electrical power network 40. When no fault is present, the electrical power network is characterizable in terms of a grid impedance Z_{g} which may be expressed in terms of a resistive part R_{g} and a reactive part X_{g}, i.e., Z_{g} = R_{g} + jX_{g}.

In the event of a fault in one of the power lines within the electrical power network 40, the impedance of the electrical power network 40 may be perturbed from the grid impedance Z_{g}, resulting in that the electrical power network 40 may operate with a short-circuit power indicative of a short-circuit ratio within at least one predetermined SCR interval characterizing the electrical power network 40 as weak, very weak, or ultra-weak. In particular, when the electrical power network 40 becomes ultra-weak, it is significantly more susceptible to instability, both in terms of loss of synchronization and voltage instability . In order to maintain power angle stability and synchronicity, the converter 10 is subsequently controlled by the control device 20 according to the enhanced power control method to stabilize the post-fault power system.

Fig. 1b schematically illustrates a power supporting system 1 according to some embodiments. The power supporting system 1 comprises a converter. The converter may be a semiconductor-based converter. That is, the converter may comprise at least one semiconductor device, such as an IGBT, MOSFET, IGCT or gate turn-off thyristor, for switching and controlling electrical power. The converter 10 may be electrically connected to a DC voltage source V_{dc} to provide electrical power to any actively controlled semiconductor devices of the semiconductor-based converter. The power supporting system 1 comprises a control device 20. The control device 20 may be configured to provide a control signal to the converter 10 for controlling an operation thereof. As a non-limiting example, the control signal may be a voltage reference. The voltage reference may be a complex voltage reference, indicating both a voltage reference and a phase reference for the converter.

The converter 10 may be configured to operate as a grid-forming converter. That is, the converter 10 may be configured to set and maintain a voltage amplitude and a frequency at the point of common connect, PCC, which other devices and systems electrically connected to the PCC can then synchronize with. The converter 10 may be configured to mimic an inertial response of a synchronous generator, helping stabilize frequency fluctuations in low-inertia grids (like those with relatively high renewable power supply). The converter 10 may be configured to adjust power provision during faults or disturbances, helping stabilize weak, very-weak, or ultra-weak electrical power networks. In the event of a blackout, the converter 10 may be configured to energize a de-energized electrical power network.

The system schematically illustrated in Fig. 1b, i.e., the power supporting system 1 and the electrical power network 40, may be characterized in terms of at least one electrical parameter. For instance, the power supporting system 1 is electrically connected to the electrical power network 40 via a first bus BUS1. The voltage v_{g} at the first bus BUS1 has a first phase θ₁. The electrical power network 40 is also electrically connected to a second bus BUS2. The voltage vₛ at the second bus BUS2 has a second phase θ₂ typically different from the first phase θ₁. Moreover, the system is illustrated having a filter reactor, e.g. represented by an inductor, L_{f}, between the power supporting system 1 and the first bus BUS1 and a capacitor C_{f} between the first bus BUS1 and electrical ground potential. A filter current may be measured via a CT. The voltage v_{g} and the current i_{g} at the first bus BUS1 may be measured via a VT and a CT respectively. The converter 10 is configured to exchange power with the electrical power network 40 via the PCC, which power is P_{g} + jQ_{g}, wherein P_{g} represents the active power and Q_{g} represents the reactive power.

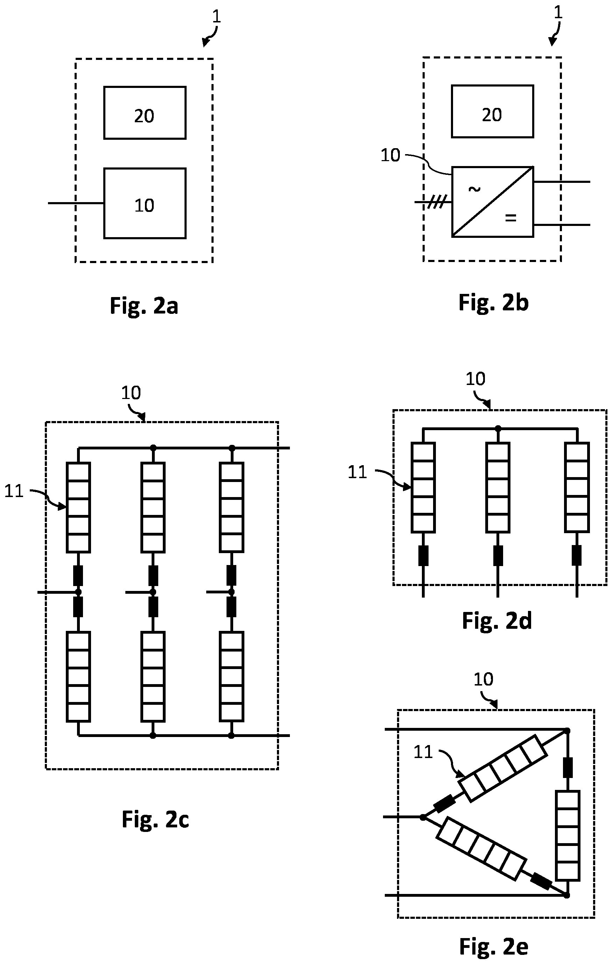

Figs. 2a-2e schematically illustrate power supporting systems 1 or components thereof according to some embodiments. The control device 20 according to any embodiment of the present disclosure may be used to control the converter 10, such as a VSC, electrically connected or electrically connectable to the electrical power network 40. As mentioned, the VSC 10 and the control device 20 may together be comprised in a power supporting system 1 for supporting an electrical power network in terms of complex power (active power and/or reactive power), frequency, voltage, current, etc., as needed. However, the control device 20 is not as such limited with respect to the VSC 10 it is configured to control. For instance, the VSC 10 may be adapted as a monolithic VSC (see Fig. 2b) or as a multi-level converter, MMC, based VSC (see Figs. 2c-2e). A monolithic VSC may refer to a VSC implementing a single integrated unit with a centralized design with a few large semiconductor devices (e.g., IGBTs or MOSFETs) to handle high voltages and currents. A MMC-based VSC may refer to a VSC that implements a modular architecture, where the VSC is composed of multiple submodules arranged in series in each phase leg. The MMC-based VSC 10 may be designed as a YY-MMC VSC (see Fig. 2c), a Y-connected chain-link VSC (see Fig. 2d), or a D-connected chain-link VSC (see Fig. 2e).

For high-voltage direct current applications, a MMC-based VSC may be preferred. As seen in Figs. 2c-2e, the MMC-based VSC 10 may comprise cells 11 arranged in respective arms as a plurality of series-connected cells 11, the number of arms being dependent on the number of phases of the power grid. As a non-limiting example, the VSC 10 may comprise three arms, each arm corresponding to a respective phase, each arm comprising a plurality of series-connected cells 11. The cells 11 of an arm of the VSC 10 may however be arranged as a plurality of series- and parallel connected cells 11. The power supporting system 1 is electrically connected or electrically connectable to a power grid. Each cell of the VSC 10 may be configured to store and provide energy depending on how the VSC is operated.

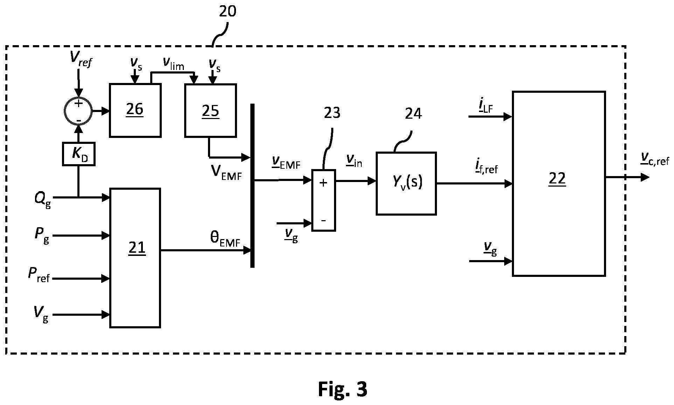

Fig. 3 schematically illustrates the aforementioned control device 20 according to some embodiments. The control device 20 is configured to control the converter 10, such as a VSC, according to an enhanced power control method. The control device 20 comprises an active power loop controller 21 for implementing at least a portion of the enhanced power control method. The active power loop controller 21 is configured to determine an electromotive force phase *θ_{EMF}* for the converter 10 based at least on one parameter of the electrical power network 40. That is, the active power loop controller 21 regulates active power by adjusting the electromotive force phase *θ_{EMF}.* Typically, the active power being exchanged between the VSC 10 and the electrical power network 40 at the PCC may be described by the following formula ${P}_{g} = \frac{{V}_{g} {V}_{s}}{X} sin \left({θ}_{2}-{θ}_{1}\right)$ wherein *V_{g}* is the voltage at the PCC (BUS1), *Vₛ* is the voltage of the electrical power network (BUS2), and *θ*₂ - *θ*₁ is the phase difference between the voltage *V_{g}* at the PCC and the voltage *Vₛ* of the electrical power network. The voltage *V_{g}* at the PCC is generally the difference between an electromotive force voltage *V_{EMF}* of the VSC and a voltage drop over a virtual impedance between the VSC electromotive force *V_{EMF}* and the PCC. The phase *θ*₁ is generally the electromotive force angle *θ_{EMF}* of the VSC adjusted by a phase shift due to the virtual impedance between the VSC electromotive force *V_{EMF}* and the PCC. This phase difference may be regulated by increasing or decreasing the electromotive force angle *θ_{EMF}.*

According to one non-limiting example, the control device 20 comprises a voltage controller 25. The voltage controller is configured to determine a voltage magnitude *V_{EMF}* of an electromotive force *V_{EMF}* of the VSC. The voltage controller 25 may be configured to receive as input the voltage *V_{g}* at the PCC. This allows the voltage controller 25 to receive feedback in the form of the voltage *V_{g}* at the PCC with regards to the electromotive force *V_{EMF}* of the VSC provided by the voltage controller 25 and may adjust the voltage magnitude accordingly.

In one exemplary embodiment, the control device 20 is configured to limit a current between the VSC 10 and the electrical power network 40 via the PCC. The control device 20 may comprise a current controller 22 for providing current tracking and limitations. The current controller 22 may be configured to regulate a current between the VSC 10 and the electrical power network 40 via the PCC based on a current reference *i*_{f,ref} for a current *i*_{Lf} between the VSC and the electrical power network 40 via the PCC. The current controller 22 may be configured to receive as input the current reference *i*_{f,ref} and output a voltage reference *v*_{c,ref} based on the current reference *i*_{f,ref}. The current controller 22 may be configured to receive as input the current reference *i*_{f,ref} and the current *i*_{Lf} between the VSC 10 and the electrical power network 40 via the PCC, and control the current *i*_{Lf} between the VSC and the electrical power network 40 based on a difference between the current reference *i*_{f,ref} and the current *i*_{Lf} via the voltage reference *v*_{c,ref}. The current controller 22 may be configured to continuously or repeatedly adjust the voltage reference to reduce a difference between the current and the current reference. The voltage reference may be determined as ${v}_{c , ref} = {v}_{g} + Z \left({i}_{ref}-{i}_{Lf}\right)$ wherein Z is the impedance between the VSC and the PCC. The current controller 22 may be configured to obtain the impedance Z as input or determine the impedance Z based on at least one other input. The impedance Z may be based on a filter, which is located between the VSC and the PCC. The filter can consist of a filter reactor.

The control device 20 may comprise a virtual admittance unit configured to determine the reference current *i_{ref}* based on a voltage *vᵢₙ* corresponding to a difference between the electromotive force *v_{EMF}* of the VSC and the voltage *v_{g}* at the PCC. The reference current *i_{f,ref}* may be determined as ${i}_{f , ref} = {Y}_{v} {v}_{in}$ wherein *Yᵥ* may be a dynamically adjustable virtual admittance and *vᵢₙ* is the voltage difference between the electromotive force *v_{EMF}* of the VSC and the voltage *v_{g}* at the PCC. That is, the virtual admittance *Yᵥ* is not necessarily a fixed value but can be adjusted by the virtual admittance unit to influence the control of the VSC 10. The virtual admittance unit 24 may function similarly to a control gain that determines how much current should flow based on the voltage difference. The virtual admittance unit can adjust the virtual admittance to stabilize the electrical power network 40 or optimize performance thereof based on operating conditions (e.g., grid strength, load changes, or faults). For example, if the electrical power network 40 is experiencing a fault resulting in the electrical power network 40 becoming weak, very weak, or ultra-weak, a lower virtual admittance *Yᵥ* may be used to prevent large current fluctuations. Conversely, if the electrical power network is strong (e.g., SCR > 5), a higher virtual admittance *Yᵥ* might be used to increase responsiveness.

As mentioned, the control device 20 comprises an active power loop controller 21 configured to determine an electromotive force angle *θ_{EMF}.* The active power loop controller 21 may be configured to receive as input a reactive power *Q_{g}*, an active power *P_{g}*, an active power reference *P_{ref}* for the active power *P_{g}*, and a voltage *V_{g}* at the PCC. The active power loop controller 21 may be configured to determine the electromotive force angle *θ_{EMF}* based at least on the received input.

The control device 20 may comprise a voltage limiting controller 26. The voltage limiting controller 26 may be configured to receive, directly or indirectly, a voltage reference as an input. The voltage limiting controller 26 may be configured to output the voltage limit *vₗᵢₘ* to the voltage controller 25, which may in turn be configured to determine the electromotive force voltage magnitude based on the voltage limit *vₗᵢₘ.* The voltage reference v_{ref}, before being received by the voltage limiting controller 26, may be adjusted based on a reactive power Q_{g} being exchanged between the VSC and the PCC. Specifically, the voltage limiting controller 26 may receive as input a difference between the voltage reference v_{ref} and a voltage droop based on the reactive power Q_{g} scaled by a factor K_{D}.

The control device is configured to implement an enhanced active power control method. The enhanced active power control method may implement a method for impedance estimation of an electrical power network 40 wherein a converter, such as a voltage source converter, VSC, is electrically connected to the electrical power network via a point of common connection, PCC. The method comprises: upon detecting a fault perturbing an impedance *Z_{g}* of the electrical power network 40 so that a per-unit impedance *Z_{g}* of the electrical power network deviates from a pre-fault value, determining a set of data points (*x*ₖ, *y*ₖ) based at least on a plurality of measurements of an active power *P_{g}* and a reactive power *Q_{g}* being exchanged between the VSC and the electrical power network via the PCC. The method comprises: performing a circle fitting on the set of data points *x*ₖ, *y*ₖ to estimate a center point *x_{c_est}*, *y_{c_est}* and a radius *r_{c_est}* of a quasi-power circle *C*_{qp} expressed using an equation of the form ${\left({P}_{traj}-{x}_{c _ est}\right)}^{2} + {\left({Q}_{traj}-{y}_{c _ est}\right)}^{2} = {r}_{c _ est}^{2}$ wherein ${P}_{traj} = function \left({P}_{g},{V}_{g},…\right)$ ${Q}_{traj} = function \left({Q}_{g},{V}_{g},…\right)$ wherein *V*_{g} corresponds to a voltage magnitude of a voltage at the PCC. The method comprises: determining an estimated impedance *Z_{g_est}* of the impedance *Z_{g}* of the electrical power network 40 by ${R}_{g _ est} = \frac{{x}_{c _ est} {Z}_{b}}{{{x}_{c _ est}}^{2} + {{y}_{c _ est}}^{2}}$ ${X}_{g _ est} = \frac{{y}_{c _ est} {Z}_{b}}{{{x}_{c _ est}}^{2} + {{y}_{c _ est}}^{2}}$ ${Z}_{g _ est} = \sqrt{{{R}_{g _ est}}^{2} + {{X}_{g _ est}}^{2}}$ wherein *R_{g_est}* corresponds to an estimated fundamental frequency resistance of the electrical power network and *X_{g_est}* corresponds to an estimated fundamental frequency reactance of the electrical power network, and *Z_{b}* corresponds to a base impedance.

The method above advantageously allows for fast and sufficiently accurate impedance estimation. By obtaining an accurate representation of impedance of the electrical power network, a control device implementing the method (or using the impedance estimation obtained by the method) may advantageously control a converter such as a VSC appropriately so that power transmission is performed with power angle stability and synchronism.

To ensure stable operation of the converter at a full rated power, a maximum power transfer capability *P*_{*line*_*max*} between the converter and the electrical power network via the PCC must exceed the converter's rated power. For a topology of an electrical power network as illustrated in e.g., Fig. 1a or Fig. 1b, with an equivalent impedance (*Z_{g} = R_{g} +jX_{g}*, the active power being exchanged between the converter and the electrical power network via the PCC may be expressed as ${P}_{g} = \frac{{V}_{g}^{2} {R}_{g} - {V}_{g} {V}_{s} {R}_{g} cos \left(δ\right) + {V}_{g} {V}_{s} {X}_{g} sin \left(δ\right)}{{{R}_{g}}^{2} + {{X}_{g}}^{2}}$ wherein *V_{g}* is the voltage magnitude of the voltage at the first bus BUS1 (PCC), *Vₛ* is the voltage magnitude of the voltage at the second bus BUS2, and *δ* is the power angle. Meanwhile, the reactive power being exchanged between the converter and the electrical power network via the PCC may be expressed as ${Q}_{g} = \frac{{V}_{g}^{2} {X}_{g} - {V}_{g} {V}_{s} {R}_{g} sin \left(δ\right) - {V}_{g} {V}_{s} {X}_{g} cos \left(δ\right)}{{{R}_{g}}^{2} + {{X}_{g}}^{2}}$

By assuming the two bus voltages *V_{g}*, *Vₛ* are closed to 1 p.u. and by neglecting the resistance *R_{g}* of the electrical power network, the maximum power transfer capability *P*_{*line*_*max*} (approximately equal to 1/*X_{g}*) is provided when the power angle $δ = \left({θ}_{1}-{θ}_{2}\right) = \frac{π}{2}$.

Further, the short-circuit ratio SCR may be expressed as $SCR = \frac{1}{{Z}_{g _ pu}} = \frac{1}{\sqrt{{{R}_{g}}^{2} + {{X}_{g}}^{2}} / {Z}_{b}}$ wherein *Z_{g_pu}* is the per-unit value of the impedance of the electrical power network, and *Z_{b}* is the base impedance of the electrical power network. When a main parallel power line trips unexpectantly as indicated e.g. in Fig. 1b (line *R*_{*g*2} *+ jX*_{*g*2} is tripped), the SCR can dramatically decrease to a lower value, potentially resulting in a short-circuit power falling below the converter's rated power, which may lead to a loss of synchronization and/or power angle instability.

One option for at least temporarily maintain or restore synchronization is to reduce active power injection by the converter to zero. However, it is preferable to maintain or restore synchronization in a way that also allows the converter to still deliver at least some active power to prevent significant imbalances between power supply and demand. The method herein disclosed, and the control device implementing it, enables this by providing an impedance estimation of the electrical power network post-fault, which then can be used for determining a new active power reference for power angle stability and control the converter so that power is being exchanged between the converter and the electrical power network at new stable operating point. Additionally, a present power angle is typically not readily available, which also makes it difficult to directly estimate the impedance of the electrical power network.

In a strong electrical power network (e.g., with corresponding SCR > 5), the power angle *δ* is typically small so any cos(*δ*)-terms in the equations for active power *P_{g}* and reactive power *Q_{g}* can be approximated as being equal to 1 and any sin(*δ*)-terms in the equations for active power *P_{g}* and reactive power *Q_{g}* can be approximated as being equal to 0. This can be utilized for providing impedance estimations of the electrical power network during strong conditions. However, when electrical power networks no longer are strong, such as due to a fault, in particular during ultra-weak conditions, the impedance of the electrical power network is much higher, which typically results in the power angle needs to increase in order to provide the same amount of active power *P_{g}* and/or reactive power *Q_{g}.* When the power angle increases, it is no longer a viable option to approximate the cos(*δ*)-terms and sin(*δ*)-terms as described above, and consequently, it is more difficult to obtain a sufficiently accurate impedance estimation of the electrical power network.

Assuming that the post-fault impedance of the electrical power network 40 remains constant but unknown, which generally is a valid approximation if there is no cascading faults, the above equations for active power and reactive power can be reformulated as ${P}_{g} = {αV}_{g}^{2} - {V}_{g} {V}_{s} \left(αcos\left(δ\right)-βsin\left(δ\right)\right)$ ${Q}_{g} = {βV}_{g}^{2} - {V}_{g} {V}_{s} \left(αsin\left(δ\right)+βcos\left(δ\right)\right)$ wherein $α = \frac{{R}_{g}}{{\left|{Z}_{g}\right|}^{2}}$ $β = \frac{{X}_{g}}{{\left|{Z}_{g}\right|}^{2}}$ $\left|{Z}_{g}\right| = \sqrt{{{R}_{g}}^{2} + {{X}_{g}}^{2}}$

Here, the parameters *α* and *β* are constant. However, the equations for active power *P_{g}* and reactive power *Q_{g}* are still formulated in terms of power angle *δ*, which typically is not obtained in real-time operation. The dependence on power angle *δ* can however be eliminated by moving all non-*δ* terms to the left side for each equation, squaring each equation, and then combine the resulting equations for active power *P_{g}* and reactive power *Q_{g}* ${P}_{g} - {αV}_{g}^{2} = - {V}_{g} {V}_{s} \left(αcos\left(δ\right)-βsin\left(δ\right)\right)$ ${Q}_{g} - {βV}_{g}^{2} = - {V}_{g} {V}_{s} \left(αsin\left(δ\right)+βcos\left(δ\right)\right)$ ${\left({P}_{g}-{αV}_{g}^{2}\right)}^{2} = {\left(-{V}_{g}{V}_{s}\left(αcos\left(δ\right)-βsin\left(δ\right)\right)\right)}^{2}$ ${\left({Q}_{g}-{βV}_{g}^{2}\right)}^{2} = {\left(-{V}_{g}{V}_{s}\left(αsin\left(δ\right)+βcos\left(δ\right)\right)\right)}^{2}$ $\begin{matrix}{\left({P}_{g}-{αV}_{g}^{2}\right)}^{2} + {\left({Q}_{g}-{βV}_{g}^{2}\right)}^{2} = \\ {\left(-{V}_{g}{V}_{s}\left(αcos\left(δ\right)-βsin\left(δ\right)\right)\right)}^{2} + {\left(-{V}_{g}{V}_{s}\left(αsin\left(δ\right)+βcos\left(δ\right)\right)\right)}^{2}\end{matrix}$ wherein the right-hand side of the last equation can be further simplified by using binomial expansion, cancelling out any cross terms, and using the Pythagorean identity *cos*²(*δ*) *+ sin*²(*δ*) = 1: $\begin{matrix}{{V}_{g}}^{2} {{V}_{s}}^{2} {\left(αcos\left(δ\right)-βsin\left(δ\right)\right)}^{2} + {{V}_{g}}^{2} {{V}_{s}}^{2} {\left(αsin\left(δ\right)+βcos\left(δ\right)\right)}^{2} \\ = {{V}_{g}}^{2} {{V}_{s}}^{2} \left[{\left(αcos\left(δ\right)-βsin\left(δ\right)\right)}^{2}+{\left(αsin\left(δ\right)+βcos\left(δ\right)\right)}^{2}\right] \\ = {{V}_{g}}^{2} {{V}_{s}}^{2} \left[\begin{matrix}{α}^{2} {cos}^{2} \left(δ\right) + {β}^{2} {sin}^{2} \left(δ\right) - 2 αβ cos \left(δ\right) sin \left(δ\right) + \\ + {α}^{2} {sin}^{2} \left(δ\right) + {β}^{2} {cos}^{2} \left(δ\right) + 2 αβ sin \left(δ\right) cos \left(δ\right)\end{matrix}\right] \\ = {{V}_{g}}^{2} {{V}_{s}}^{2} \left[{α}^{2}{cos}^{2}\left(δ\right)+{β}^{2}{sin}^{2}\left(δ\right)+{α}^{2}{sin}^{2}\left(δ\right)+{β}^{2}{cos}^{2}\left(δ\right)\right] \\ = {{V}_{g}}^{2} {{V}_{s}}^{2} \left[{α}^{2}\left({cos}^{2}\left(δ\right)+{sin}^{2}\left(δ\right)\right)+{β}^{2}\left({cos}^{2}\left(δ\right)+{sin}^{2}\left(δ\right)\right)\right] \\ = {{V}_{g}}^{2} {{V}_{s}}^{2} \left[{α}^{2}+{β}^{2}\right]\end{matrix}$

Thus, a relationship between active power and reactive power which does not depend on the power angle *δ* is obtained: ${\left({P}_{g}-{αV}_{g}^{2}\right)}^{2} + {\left({Q}_{g}-{βV}_{g}^{2}\right)}^{2} = {{V}_{g}}^{2} {{V}_{s}}^{2} \left[{α}^{2}+{β}^{2}\right]$

This equation can be further simplified by substituting the parameters *α* and *β* as defined above: ${\left({P}_{g}-{αV}_{g}^{2}\right)}^{2} + {\left({Q}_{g}-{βV}_{g}^{2}\right)}^{2} = {{V}_{g}}^{2} {{V}_{s}}^{2} \left[{\left(\frac{{R}_{g}}{{\left|{Z}_{g}\right|}^{2}}\right)}^{2}+{\left(\frac{{X}_{g}}{{\left|{Z}_{g}\right|}^{2}}\right)}^{2}\right]$ ${\left({P}_{g}-{αV}_{g}^{2}\right)}^{2} + {\left({Q}_{g}-{βV}_{g}^{2}\right)}^{2} = {{V}_{g}}^{2} {{V}_{s}}^{2} \left[\frac{1}{{\left|{Z}_{g}\right|}^{4}}{\left({{R}_{g}}^{2}+{{X}_{g}}^{2}\right)}^{2}\right]$ ${\left({P}_{g}-{αV}_{g}^{2}\right)}^{2} + {\left({Q}_{g}-{βV}_{g}^{2}\right)}^{2} = {{V}_{g}}^{2} {{V}_{s}}^{2} \left[\frac{1}{{\left|{Z}_{g}\right|}^{4}}{\left|{Z}_{g}\right|}^{2}\right]$ ${\left({P}_{g}-{αV}_{g}^{2}\right)}^{2} + {\left({Q}_{g}-{βV}_{g}^{2}\right)}^{2} = \frac{{{V}_{g}}^{2} {{V}_{s}}^{2}}{{\left|{Z}_{g}\right|}^{2}}$ ${\left({P}_{g}-{αV}_{g}^{2}\right)}^{2} + {\left({Q}_{g}-{βV}_{g}^{2}\right)}^{2} = {\left(\frac{{V}_{g} {V}_{s}}{\left|{Z}_{g}\right|}\right)}^{2}$

From this, it can be seen that if the bus voltages *V_{g}* and *Vₛ* remain constant, then the equation above may be seen to be on the form of an equation of a circle ${\left(x-h\right)}^{2} + {\left(y-k\right)}^{2} = {r}^{2}$ wherein *(h, k)* is the center of the circle, r is the radius of the circle, and (*x*, *y*) are the coordinates of any point on the circle.

However, the derived equation above relating active power *P_{g}* and reactive power *Q_{g}* depend on the voltage magnitude *V_{g}* at the PCC which is not necessarily constant during a transient SCR drop, which causes variations in both the circle center and radius. To mitigate these impacts and account for the units, by multiplying both sides with $\frac{{Z}_{b}^{2}}{{U}_{g}^{2}}$, the above equation may be reformulated as ${\left(\frac{{P}_{g} {Z}_{b}}{{V}_{g}^{2}}-{αZ}_{b}\right)}^{2} + {\left(\frac{{Q}_{g} {Z}_{b}}{{V}_{g}^{2}}-{βZ}_{b}\right)}^{2} = {\left(\frac{{V}_{s} {Z}_{b}}{{V}_{g} \left|{Z}_{g}\right|}\right)}^{2}$ wherein ${Z}_{b} = {V}_{b}^{2} / {S}_{b}$ with *Z_{b} , V_{b}* and *S_{b}* represent base values of the impedance, the voltage and the power, respectively.

The equation above forms a circle, which may be referred to as a quasi-power circle *C_{qp}*, centered at (*αZ_{b}*, *βZ_{b}*) with a stable radius $\frac{{V}_{s} {Z}_{b}}{{V}_{g} \left|{Z}_{g}\right|}$. The quasi-power circle maintains a fixed center when the equivalent impedance remains unchanged after the transient SCR reduction.

This equation can thus be leveraged for determining an impedance of the electrical power network post-fault by recording a sufficient number of quasi-power trajectory points (*Pₜᵣₐⱼ*, *Qₜᵣₐⱼ*) defined as ${P}_{traj} = \frac{{P}_{g} {Z}_{b}}{{V}_{g}^{2}}$ ${Q}_{traj} = \frac{{Q}_{g} {Z}_{b}}{{V}_{g}^{2}}$ **to estimate** a circle center (*x*_{*c*_*est*}, *y_{c_est}*) and a radius *r_{c_est}.* That is, the equation of the quasi-power circle may be reformulated as ${\left({P}_{traj}-{x}_{c _ est}\right)}^{2} + {\left({Q}_{traj}-{y}_{c _ est}\right)}^{2} = {\left({r}_{c _ est}\right)}^{2}$ wherein *x_{c_est}* = *αZ_{b}*, *y_{c_est}* = *βZ_{b}*, and ${r}_{c _ est} = \frac{{V}_{s} {Z}_{b}}{{V}_{g} \left|{Z}_{g}\right|}$.

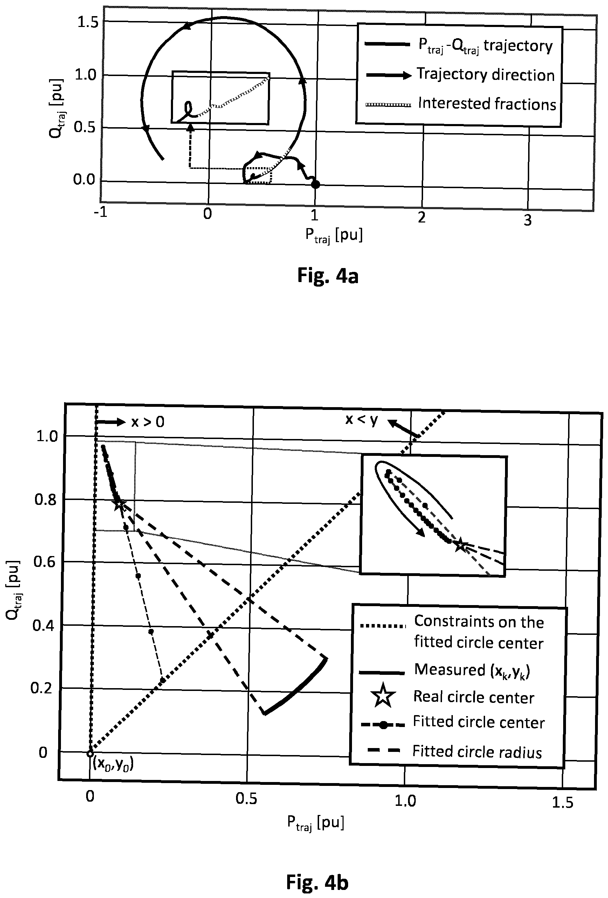

Fig. 4a illustrates how the transient SCR impacts the active power and reactive power in terms of the parameters *Pₜᵣₐⱼ*, *Qₜᵣₐⱼ.* The parameters *Pₜᵣₐⱼ*, *Qₜᵣₐⱼ* wander from a stable operating pont (indicated by black dot) along a *Pₜᵣₐⱼ - Qₜᵣₐⱼ* trajectory indicated by the solid line, and the trajectory direction indicated by arrows. Once the quasi-power circle stabilizes following a transient SCR drop, the *Pₜᵣₐⱼ - Qₜᵣₐⱼ* trajectory forms an approximate circle. Thus, the quasi-power trajectory points (*Pₜᵣₐⱼ*, *Qₜᵣₐⱼ*) are recorded among interested fractions as soon as the quasi-power circle stabilizes. The parameters of the circle, i.e., the circle center (*x*_{*c*_*est*}, *y_{c_est}*) and the radius *r_{c_est}*, can be approximated by performing a circle fitting on the set of data points (*x*ₖ, *y*ₖ) = (*P*ₜᵣₐⱼ(*k*), Qₜᵣₐⱼ(*k*)). Once the circle center is determined, the impedance of the electrical power network may be determined using the following equations ${R}_{g _ est} = \frac{{x}_{c _ est} {Z}_{b}}{{{x}_{c _ est}}^{2} + {{y}_{c _ est}}^{2}}$ ${X}_{g _ est} = \frac{{y}_{c _ est} {Z}_{b}}{{{x}_{c _ est}}^{2} + {{y}_{c _ est}}^{2}}$ ${Z}_{g _ est} = \sqrt{{{R}_{g _ est}}^{2} + {{X}_{g _ est}}^{2}}$ wherein *R_{g_est}* corresponds to an estimated fundamental frequency resistance of the electrical power network and *X_{g_est}* corresponds to an estimated fundamental frequency reactance of the electrical power network.

The above equations are obtained by ${x}_{c _ est} = {αZ}_{b} = \frac{{R}_{g _ est} {Z}_{b}}{{\left|{Z}_{g _ est}\right|}^{2}} = \frac{{R}_{g _ est} {Z}_{b}}{{{R}_{g _ est}}^{2} + {{X}_{g _ est}}^{2}}$ ${y}_{c _ est} = {βZ}_{b} = \frac{{X}_{g _ est} {Z}_{b}}{{\left|{Z}_{g _ est}\right|}^{2}} = \frac{{X}_{g _ est} {Z}_{b}}{{{R}_{g _ est}}^{2} + {{X}_{g _ est}}^{2}}$ wherein *R_{g}*, *X_{g}*, *Z_{g}* are estimated by *R_{g_est}*, *X_{g_est}*, *Z_{g_est}.* ${{x}_{c _ est}}^{2} + {{y}_{c _ est}}^{2} = {\left(\frac{{R}_{g _ est} {Z}_{b}}{{{R}_{g _ est}}^{2} + {{X}_{g _ est}}^{2}}\right)}^{2} + {\left(\frac{{X}_{g _ est} {Z}_{b}}{{{R}_{g _ est}}^{2} + {{X}_{g _ est}}^{2}}\right)}^{2}$ ${{x}_{c _ est}}^{2} + {{y}_{c _ est}}^{2} = \frac{\left({{R}_{g _ est}}^{2}+{{X}_{g _ est}}^{2}\right) {{Z}_{b}}^{2}}{{\left({{R}_{g _ est}}^{2}+{{X}_{g _ est}}^{2}\right)}^{2}} = \frac{{{Z}_{b}}^{2}}{{{R}_{g _ est}}^{2} + {{X}_{g _ est}}^{2}} = \frac{{{Z}_{b}}^{2}}{{\left|{Z}_{g _ est}\right|}^{2}}$

It can be seen by comparison that $\frac{{Z}_{b}}{{\left|{Z}_{g _ est}\right|}^{2}} = \frac{{x}_{c _ est}}{{R}_{g _ est}} = \frac{{y}_{c _ est}}{{X}_{g _ est}}$ which identities can be applied to re-arrange the equations above as $\begin{matrix}{{x}_{c _ est}}^{2} + {{y}_{c _ est}}^{2} = \frac{{x}_{c _ est} {Z}_{b}}{{R}_{g _ est}} \\ \to {R}_{g _ est} = \frac{{x}_{c _ est} {Z}_{b}}{{{x}_{c _ est}}^{2} + {{y}_{c _ est}}^{2}}\end{matrix}$ $\begin{matrix}{{x}_{c _ est}}^{2} + {{y}_{c _ est}}^{2} = \frac{{y}_{c _ est} {Z}_{b}}{{X}_{g _ est}} \\ \to {X}_{g _ est} = \frac{{y}_{c _ est} {Z}_{b}}{{{x}_{c _ est}}^{2} + {{y}_{c _ est}}^{2}}\end{matrix}$

The accuracy of the impedance estimation is dependent on the accuracy of the estimated fundamental frequency resistance *R_{g_est}* of the electrical power network and the estimated fundamental frequency reactance *X_{g_est}* of the electrical power network, each of which in turn depend on the accuracy of the estimated center point of the quasi-power circle. As such, the method of circle fitting is selected based on accuracy and/or computational efficiency and/or computational speed. However, it should be understood that the estimation of the center point (*x*_{*c*_*est*}, *y_{c_est}*) and the radius (*r_{c_est}*) of the quasi-power circle (*C*_{qp}) may comprise many different methods, including but not limited to algebraic fitting methods (such as least-mean squares method); geometric fitting methods (such as RANSAC algorithms); adaptive filtering methods (such as Recursive least-mean squares or Kalman filter methods); Bayesian estimation methods (such as extended Kalman filter methods), and transform-based methods (such as Hough transform methods).

In the following non-limiting example, which is illustrated in Fig. 4b, a recursive least-mean squares (RMS) method was used. Although a circle can theoretically be calculated with three non-collinear points, noise in real systems degrades measurements, so using multiple data points leads to a more precise fit. Additionally, a sudden shift to ultra-weak grid conditions causes a sudden drop in active power *P_{g}*, which may serve as an initial indicator of a fault. That is, the method may comprise computing a change of active power Δ*P_{g}* at the PCC, and detecting the fault when the change of active power Δ*P_{g}* at the PCC exceeds a predetermined threshold. When this occurs, a process of recording the data set of points (*x*ₖ, *y*ₖ) = (*P*ₜᵣₐⱼ(*k*), *Q*ₜᵣₐⱼ(*k*)) may start. Meanwhile, a converter electrically connected to the electrical power network may attempt to stabilize the electrical power network and stabilize voltage and current at the PCC. However, this does not happen immediately, so there may be a certain erraticism present in the parameters *P*ₜᵣₐⱼ, *Q*ₜᵣₐⱼ, making them unsuitable for being used in curve fitting. Thus, it may be advantageous to implement a delay before starting to record datapoints (or denote a certain initial recorded datapoints as unsuitable) until the converter provides stability post-fault.

A method of determining the delay may comprise computing an error value *Err_{stageI}* based at least on the at least one local parameter, such as *P*ₜᵣₐⱼ, *Q*tᵣₐⱼ; determining whether the error value is outside a predetermined error interval, and determining a start time of the circle fitting based at least on whether the error value is outside a predetermined error interval. According to a non-limiting example, the error value may be determined as ${Err}_{stageI} = \sum \left[{\left({P}_{traj}-{P}_{traj _ ave}\right)}^{2}+{\left({Q}_{traj}-{Q}_{traj _ ave}\right)}^{2}\right]$ wherein *P_{traj_ave}* and *Q*_{*traj*_*ave*} are sliding window filtered values of *Pₜᵣₐⱼ* and *Qₜᵣₐⱼ*, respectively. When the error value *Err_{stageI}* is sufficiently small, i.e., is below a predetermined error threshold defining the predetermined error interval, the process of recording the data set of points (*x*ₖ, *y*ₖ) = (*P*ₜᵣₐⱼ(*k*), *Q*ₜᵣₐⱼ(*k*)) may start.

Provided that *n* sets of coordinates are recorded, two matrices *X* and *Y* can be constructed as follows $X = {\left[\begin{matrix}2 {x}_{1} & 2 {y}_{1} & 1 \\ 2 {x}_{2} & 2 {y}_{2} & 1 \\ ⋮ & ⋮ & ⋮ \\ 2 {x}_{n} & 2 {y}_{n} & 1\end{matrix}\right]}_{nx 3}$ $Y = {\left[\begin{matrix}- {x}_{1}^{2} - {y}_{1}^{2} \\ - {x}_{2}^{2} - {y}_{2}^{2} \\ ⋮ \\ - {x}_{n}^{2} - {y}_{n}^{2}\end{matrix}\right]}_{nx 1}$

The relationship between the matrices *X* and *Y* can be represented as $Y = Xλ + ε$ where *λ* is a three-element column vector, [*λ*₁,*λ*₂,*λ*₃]*^{T}*, containing the parameters required for fitting the quasi-power circle, and *ε* represents the error term. To minimize the sum of squared residuals ∥*ε*∥₂, a least squared method can be applied. Therefore, *λ* can be estimated using $λ = arg min {\left‖ε\right‖}_{2} = {\left({X}^{T}X\right)}^{- 1} \left({X}^{T}Y\right)$

Based on the estimated *λ*, the center of the quasi-power circle can be calculated as $\left\{\begin{matrix}{x}_{c _ est} = - {λ}_{1} \\ {y}_{c _ est} = - {λ}_{2}\end{matrix}\right.$

In order to reduce computation and memory demands, and removing the necessity of having a complete set of datapoints, a recursive least squares method may be employed. This approach updates a present circle fitting result using new measurements corresponding to a new time instance while retaining some information from the set of datapoint available in a prior time instance. This also relaxes the required delay time before starting the process of circle fitting.

According to a non-limiting example, the RLS-based circle fitting algorithm may be given by $\left\{\begin{matrix}{X}_{k} = \left[2{x}_{k},2{y}_{k},1\right] \\ {Y}_{k} = - {x}_{k}^{2} - {y}_{k}^{2} \\ {K}_{k} = \frac{{P}_{k - 1} {X}_{k}}{{λ}_{FF} + {X}_{k}^{T} {P}_{k - 1} {X}_{k}} \\ {λ}_{k} = {λ}_{k - 1} + {K}_{k} \left({Y}_{k}-{X}_{k}^{T}{λ}_{k - 1}\right) \\ {P}_{k} = \left({P}_{k - 1}-{K}_{k}{X}_{k}^{T}{P}_{k - 1}\right) / {λ}_{FF}\end{matrix}\right.$

Wherein the subscripts k denotes the variables at the k-th iteration, and *Kₖ* and *Pₖ* are the k-th correction matrix and co-variance matrix, respectively, and *λ_{FF}* is a forgetting factor specifying how much the previous data impacts new measurements.

As can be seen in Fig. 4b, a set of datapoints (*xₖ*, *yₖ*) are obtained, indicated by a solid line, and the RLS-based circle fitting is employed to iteratively fit the circle center, which is indicated by dots. Over the iterations, the fitted circle center approaches the real circle center indicated by a star. The radius is also fitted, illustrated by dashed lines. Fig. 4b also illustrates a zoomed-in portion close to the real circle center, illustrating how the circle fitting process moves the fitted circle center closer to the real circle center. By reducing a position deviation between a position of the fitted circle center and the actual circle center, the impedance estimation may advantageously be improved.

As mentioned above, a RLS-based circle fitting may be employed. In certain situations, the fitted circle center may converge to an incorrect position due to transient power oscillations. Based on the physical interpretation of the true quasi-power circle center, where both coordinates are positive and the power line is typically inductive, the estimated circle center is subject to the constraint *y_{c_est} > x_{c_est} >* 0. In other words, the circle fitting process may begin to check for convergence only when the center of the fitted circle lies within the constrained range, illustrated by dotted lines in Fig. 4b.

It should be understood that the circle fitting may be an iterative process, as explained above, and in such a case, the method comprises: terminating the fitting process based at least on one termination condition, wherein the termination condition is at least one of: a convergence criteria of the radius and/or the circle center: a maximum number of iterations, and a variance being below a predetermined variance threshold. The method may employ any combinations of the aforementioned termination conditions. This may increase robustness of the circle fitting process. When the fitted circle center stabilizes at a certain position and no longer changes with new measurements input, the algorithm terminates the fitting process and provides the impedance estimation of the electrical power network.

According to one non-limiting example, the termination condition is a variance *Var_{cc}* being below a predetermined variance threshold *Varₜₕ*, and the method comprises: computing the variance *Var_{cc}* between a newest fitted circle center (*x*_{*c*_}*ₑₛₜ[k], y*_{*c*_}*ₑₛₜ[k])* and the M previous fitted circle centers as ${Var}_{cc} = \frac{1}{M} {\sum }_{i = 1}^{M} \left[{\left({x}_{c _ est}\left[k\right]-{x}_{c _ est}\left[k-i\right]\right)}^{2}+{\left({y}_{c _ est}\left[k\right]-{y}_{c _ est}\left[k-i\right]\right)}^{2}\right]$ and terminating the circle fitting when the variance is below the predetermined threshold *Varₜₕ.* When the real-time calculated variance *Var_{cc}* of the fitted circle center is below the predetermined variance threshold *Varₜₕ* the circle-fitting process may be terminated.

In addition, the robustness of the method may be further improved by providing a set of virtual quasi-power points (*xₖ'*, *yₖ'*) near the quasi-power circle *C*_{qp}. The virtual quasi-power points may be stochastically distributed near the quasi-power circle *C*_{qp} based on a present dataset of (*xₖ*, *yₖ*), thus increasing the size of the dataset used in the circle-fitting process. If an iterative process is implemented, this may improve convergence of the circle-fitting process. When employing virtual points, it may also be of interest to weight the impact of such virtual points by a weight factor *αᵥ*. In such a case, the k-th correction matrix K may be determined as ${K}_{k} = \frac{{P}_{k - 1} {X}_{k}}{{λ}_{FF} / {α}_{v} + {X}_{k}^{T} {P}_{k - 1} {X}_{k}}$

This may in particular be applicable for a virtual point (*x*₀, *y*₀) = (0, 0) which corresponds to the case wherein the power angle is close to 0, i.e., *Pₜᵣₐⱼ* = 0. For this case, the impedance is primarily inductive (*X_{g}* ≫ *R_{g}*) and if assuming the bus voltage magnitudes *V_{g}* and *Vₛ* are at least initially close to nominal base values, *y*₀ can be approximated as being equal to zero. This may result in the k-th correction matrix K may be determined as ${K}_{k} = \frac{{P}_{k - 1} {X}_{0}}{{λ}_{FF} / {α}_{v} + {X}_{0}^{T} {P}_{k - 1} {X}_{0}}$ wherein *X*₀ = [0,0,1], and *Y*₀ = 0.

Once an impedance estimation has been obtained, a control signal for controlling the converter may be adjusted so that the converter is controlled based on the estimated impedance.

As an example, the method may comprise generate a VSC voltage reference based at least on an active power reference *P_{ref}* for an active power *P_{g}* being exchanged between the VSC and the electrical power network, wherein the active power reference *P_{ref}* is determined based at least on an estimated impedance *Z_{g_est}* determined by the method according to some embodiments. The active power reference *P_{ref}* may be determined as ${P}_{ref} = {αP}_{line _ max}$ wherein *α* is a predetermined scaling factor which is positive and smaller than 1 and *P*_{*line*_*max*} is the maximum active power transfer capacity determined as ${P}_{line _ max} = \frac{{R}_{g _ est}}{{\left|{Z}_{g _ est}\right|}^{2}} {{V}_{g}}^{2} + \frac{1}{\left|{Z}_{g _ est}\right|} {V}_{g}$

Having determined the active power reference Pref, the control signal (e.g., a VSC voltage reference) may be provided to the VSC 10 for controlling the VSC.

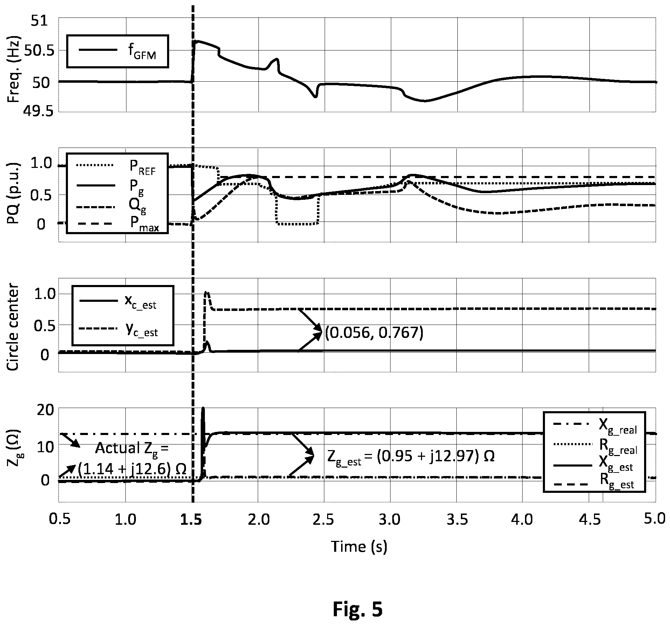

Fig. 5 illustrates a time evolution of a control operation of a converter electrically connected to an electrical power network via a PCC when said control operation is based on an estimated impedance by the method according to some embodiments after a fault (a power line is tripped, see e.g., Fig. 1a) resulting in a SCR drop from 4 pre-fault to 0.8 post-fault. Specifically, Fig. 5 comprises four graphs including (from top to bottom): a first graph illustrating the fundamental frequency of the VSC over time after a fault; a second graph illustrating active power, and reactive power being exchanged between the converter and the electrical power network, in addition to a power reference for said active power and a estimated maximum power transmission capability of the post-fault electrical power network, over time after a fault; a third graph illustrating the coordinates of the circle center determined by RLS-based circle fitting; and a fourth graph illustrating the actual impedance and the estimated impedance. The fault occurs at approximately 1.5 s, causing the impedance of the electrical power network to be disturbed. This in turn results in frequency, active power and reactive power changing over time. In the first graph, which illustrates the fundamental frequency by a solid line, it can be seen that the fundamental frequency deviates from 50 Hz at the time of the fault. In the second graph, it can be seen that the active power illustrated by a solid line drops from a pre-fault level of 1 p.u. while the reactive power illustrated by a dashed line increases from a pre-fault level of ~0 p.u. The control device, attempting to stabilize the power transmission, provides a power reference indicated by dotted line.

In response to the fault, the control device implementing the method of impedance estimation performs a circle fitting as illustrated in the third graph, wherein the x-coordinate is illustrated by solid line and y-coordinate is illustrated by a dashed line. This circle fitting results in a convergence of a circle center (*x*_{*c*_*est*}, *y_{c_esc}*) of the quasi-power circle (*C*_{qp}) at (0.056, 0.767). Based on this circle center, the control device then estimates the impedance as *Z_{g_est}* = (0.95 + *j*12.97)Ω as illustrated in the fourth graph, wherein the actual impedance in this simulated scenario is *Z_{g} =* (1.14 + *j*12.6)Ω. The real resistance and the real reactance are illustrated in the fourth graph as dashed line and dotted/dashed line respectively. Meanwhile, the estimated resistance and the estimated reactance are illustrated as dashed line and solid line respectively. Using the impedance estimation, the control device determines a new active power reference for the converter.

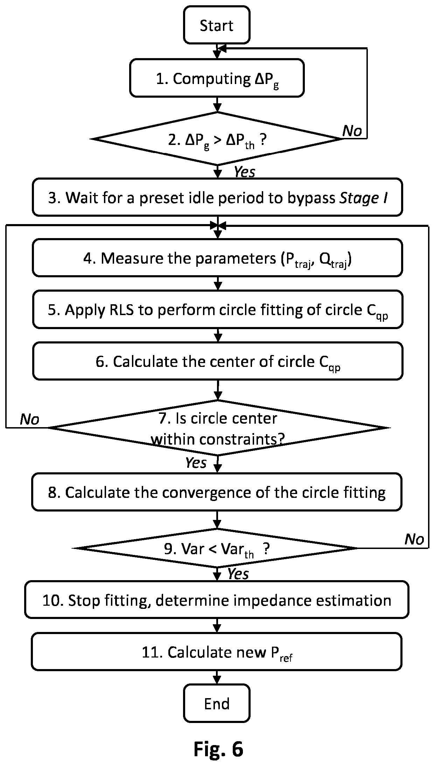

Figs. 6 illustrates a flow chart of a method of controlling a converter according to some embodiments. The method comprises an embodiment of the aforementioned method of impedance estimation. In a first step, the control device implementing the method computes a change of active power Δ*P_{g}* at the PCC. In a second step, the control device evaluates whether the change of active power Δ*P_{g}* at the PCC exceeds a predetermined threshold Δ*Pₜₕ.* If it doesn't, the control device reverts back to the first step. If it does, the control device waits for a preset idle period to bypass Stage I transients after a fault indicated by the change of active power Δ*P_{g}* exceeding the predetermined threshold Δ*Pₜₕ.* This preset idle period may in some embodiments pertain to computing the aforementioned error value by the aforementioned error function. In a fourth step, the control device records a set of data points (*x*ₖ, *y*ₖ) based on the parameters *x*ₖ = *P*ₜᵣₐⱼ(*k*), *y*ₖ = *Q*ₜᵣₐⱼ(*k*) which are determined based at least on measurements of voltages and currents at the PCC. In a fifth step, the control device applies RLS-based circle fitting to determine the quasi-power circle *C*_{qp}. The control device determines whether the circle center is within the aforementioned constraints. If it isn't, the method continues to record data points (*x*ₖ, *y*ₖ). If it is, the control device in an eight step calculates the convergence of the circle fitting based on variance. In a nineth step, the control device evaluates whether the variance is below a variance threshold. If it isn't, the method continues to record data points (*x*ₖ, *y*ₖ). If it is, the control device in a tenth step terminates the circle fitting, and determines the impedance estimation based on the estimated circle fitting according to the aforementioned equations. In an eleventh step, the control device determines a new active power reference for the converter.

The new active power reference P_{ref} is determined, and the converter is controlled according to the new active power reference. This is illustrated in Fig. 5, wherein the effect thereof is that the converter for the ultra-weak electrical power network is capable of stabilizing the electrical power network as indicated by the fundamental frequency being restored to 50 Hz and the active power and the reactive power stabilizing in the time period of around 4.5 - 5 s. Thus, as the active power and reactive power are stabilized at a new power angle, power angle instability is prevented. Likewise, synchronicity is also restored and maintained.

While the foregoing is directed to embodiments of the disclosure, other and further embodiments may be devised without parting from the inventive concept discussed herein. The scope of the invention is however determined by the claims.

## Claims

1. A computer-implemented method for impedance estimation of an electrical power network, wherein a voltage source converter, VSC, is electrically connected to the electrical power network via a point of common connection, PCC, the method comprising:
upon detecting a fault perturbing an impedance (*Z_{g}*) of the electrical power network so that a per-unit impedance (*Z_{g}*) of the electrical power network deviates from a pre-fault value, determining a set of data points (*x*ₖ, *y*ₖ) based at least on a plurality of measurements of an active power (*P_{g}*) and a reactive power (*Q_{g}*) being exchanged between the VSC and the electrical power network via the PCC;
performing a circle fitting on the set of data points (*x*ₖ, *y*ₖ) to estimate a center point (*x*_{*c*_*est*}, *y_{c_esc}*) and a radius (*r_{c_est}*) of a quasi-power circle (*C*_{qp}) expressed using an equation of the form ${\left({P}_{traj}-{x}_{c _ est}\right)}^{2} + {\left({Q}_{traj}-{y}_{c _ est}\right)}^{2} = {r}_{c _ est}^{2}$ wherein ${P}_{traj} = function \left({P}_{g},{V}_{g},…\right)$ ${Q}_{traj} = function \left({Q}_{g},{V}_{g},…\right)$
wherein *V*_{g} corresponds to a voltage magnitude of a voltage at the PCC, and
determining an estimated impedance (*Z_{g_est}*) of the impedance (*Z_{g}*) of the electrical power network by ${R}_{g _ est} = \frac{{x}_{c _ est} {Z}_{b}}{{{x}_{c _ est}}^{2} + {{y}_{c _ est}}^{2}}$ ${X}_{g _ est} = \frac{{y}_{c _ est} {Z}_{b}}{{{x}_{c _ est}}^{2} + {{y}_{c _ est}}^{2}}$ ${Z}_{g _ est} = \sqrt{{{R}_{g _ est}}^{2} + {{X}_{g _ est}}^{2}}$
wherein *R_{g_est}* corresponds to an estimated fundamental frequency resistance of the electrical power network and *X_{g_est}* corresponds to an estimated fundamental frequency reactance of the electrical power network.

2. The method according to claim 1, wherein *P*ₜᵣₐⱼ, *Q*ₜᵣₐⱼ are determined by ${P}_{traj} = \frac{{P}_{g} {Z}_{b}}{{V}_{g}^{2}}$ ${Q}_{traj} = \frac{{Q}_{g} {Z}_{b}}{{V}_{g}^{2}}$ wherein *P*ₜᵣₐⱼ, *Q*ₜᵣₐⱼ define a plurality of quasi-power points of the quasi-power circle (*C*_{qp}), *V*_{g} corresponds to a voltage magnitude of a voltage at the PCC, and *P*_{g} and *Q*_{g} are based on measurements of voltage (*V*_{g}) and current (*I*_{g}) at the PCC.

3. The method according to any one of claims 1-2, wherein the set of data points (*x*ₖ, *y*ₖ) are defined as ${x}_{k} = {P}_{traj} \left(k\right)$ ${y}_{k} = {Q}_{traj} \left(k\right)$ wherein k indicates a *k*:th data point.

4. The method according to any one of the preceding claims, wherein the radius (*r_{c_est}*) of the quasi-power circle (*C*_{qp}) is approximated as ${r}_{c _ est} \approx \frac{{V}_{s} {Z}_{b}}{{V}_{g} \left|{Z}_{g _ est}\right|}$ wherein *Vₛ* is the voltage magnitude of the voltage of the electrical power network and |*Z_{g_est}*| is the absolute value of the estimated fundamental frequency impedance of the electrical power network.

5. The method according to claim 4, wherein the radius *r*_{*c*_*est*} is approximated using parameters (*Vₛ*, *Z_{b}*, *V_{g}*, *Z_{g_est}*) expressed relative a respective base value, and the voltage magnitude of the voltage of the electrical power network (*Vₛ*) is selected to be equal to 1 per unit base value.

6. The method according to any one of the preceding claims, comprising computing a change of active power (Δ*P_{g}*) at the PCC, and detecting the fault when the change of active power (Δ*P_{g}*) at the PCC exceeds a predetermined threshold.

7. The method according to any one of the preceding claims, comprising
computing an error value (*Err_{stageI}*) based at least on the at least one local parameter;
determining whether the error value is outside a predetermined error interval, and
determining a start time of the circle fitting based at least on whether the error value is outside a predetermined error interval.

8. The method according to any one of claims 1-7, wherein the estimation of the center point (*x*_{*c*_*est*}, *y_{c_esc}*) and the radius (*r_{c_est}*) of the quasi-power circle (*C*_{qp}) comprises at least one of: an algebraic fitting method; a geometric fitting method; an adaptive filtering method; a Bayesian estimation method, and a transform-based method.

9. The method according to any one of the preceding claims, wherein the circle fitting is an iterative process, and the method comprises:
terminating the fitting process based at least on one termination condition, wherein the termination condition is at least one of:
a convergence criteria of the radius and/or the circle center:
a maximum number of iterations, and
a variance (*Var_{cc}*) being below a predetermined variance threshold (*Varₜₕ*).

10. The method according to any of the preceding claims, wherein said circle fitting is further based at least on a set of virtual quasi-power points (*x*₀, *y*₀) near the quasi-power circle (*C*_{qp}).

11. The method according to any of the preceding claims, wherein, during the detected fault, the electrical power network operates with a short-circuit ratio, SCR, within at least one predetermined SCR interval.

12. The method according to claim 11, wherein the SCR is determined as $SCR = \frac{1}{{Z}_{g _ est}} = \frac{1}{\sqrt{{{R}_{g _ est}}^{2} + {{X}_{g _ est}}^{2}} / {Z}_{b}}$

13. A control device (20) configured to control a voltage source converter, VSC, electrically connected to an electrical power network via a point of common connection, PCC, the control device configured to:
generate a VSC voltage reference based at least on an active power reference (*P_{ref}*) for an active power (*P_{g}*) being exchanged between the VSC and the electrical power network,
wherein the active power reference (*P_{ref}*) is determined based at least on an estimated impedance (*Z_{g_est}*) determined by the method according to any one of the preceding claims,
wherein the control device (20) is configured to provide the VSC voltage reference to the VSC (10) for controlling the VSC.

14. The control device (20) according to claim 13, wherein the active power reference is determined as ${P}_{ref} = {αP}_{line _ max}$ wherein *α* is a predetermined scaling factor which is positive and smaller than 1 and *P*_{*line*_*max*} is the maximum active power transfer capacity determined as ${P}_{line _ max} = \frac{{R}_{g _ est}}{{\left|{Z}_{g _ est}\right|}^{2}} {{V}_{g}}^{2} + \frac{1}{\left|{Z}_{g _ est}\right|} {V}_{g}$

15. Power supporting system (1) comprising:
a voltage source converter, VSC, (10) configured to be electrically connectable to an electrical power network (40) via a point-of-common-coupling, PCC, and
a control device (20) according to any one of claims 13-14.
